(19) Europäisches Patentamt

European Patent Office

Office européen des brevets

(11) **EP 4 651 379 A2**

(12) **EUROPEAN PATENT APPLICATION**

(43) Date of publication:
**19.11.2025 Bulletin 2025/47**

(21) Application number: **25201244.8**

(22) Date of filing: **09.09.2025**

(51) International Patent Classification (IPC):
**H03M 1/06** (2006.01)    **H03M 1/08** (2006.01)
**H03M 1/36** (2006.01)

(52) Cooperative Patent Classification (CPC):
**H03M 1/361; H03M 1/0607; H03M 1/08**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(71) Applicants:
• **NXP B.V.**
  **5656 AG Eindhoven (NL)**
• **University Of Twente**
  **7522 NB  Enschede (NL)**

(72) Inventors:
• **OLIEMAN, Erik**
  **5656AG Eindhoven (NL)**

• **VAN DE BEEK, Remco Cornelis Herman**
  **5656AG Eindhoven (NL)**
• **VAN SINDEREN, Jan**
  **5656AG Eindhoven (NL)**
• **CENTS, Remon Bernardus Antonius**
  **5656AG Eindhoven (NL)**
• **BINDRA, Hariot Singh**
  **5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **A CAPACITIVE CHARGE METHOD AND CIRCUIT FOR A DIFFERENTIAL COMPARATOR FOR AN ADC**

(57)     Aspects of this disclosure are directed to a circuit for a flash ADC converter, comprising: a differential input; a comparator having an output, and first and second input at first and second nodes; reference capacitors, ach having a first terminal respectively connected to first and second nodes, and a second terminal connectable respectively to a supply and to a second supply voltage; first and second reservoir capacitor, each having a first terminal connected to the second supply voltage, and a second terminal connectable respectively to the first and second node; and a plurality of switches controllable to: operate a first charge-setting phase, a second charge-sharing phase, and a third, measurement phase. A corresponding method is also disclosed.

*Fig. 1a*

*Fig. 1b*

**EP 4 651 379 A2**

**Description**

FIELD OF THE DISCLOSURE

This present disclosure to circuits and methods for flash analog to digital converters (ADCs).

BACKGROUND

Flash ADCs are used in a wide-variety of ADCs) for example stand-alone or as part of hybrid ADCs e.g., flash-assisted pipeline and/or successive approximation register (SAR) ADCs. Typically, the voltage reference levels for the individual comparators are generated in such a way that the common-mode voltage at the input of the comparators is variable or by dividing the input signal itself.

The present disclosure teaches an alternative method to generate the differential voltage reference level for a comparator, and circuits therefor, .

SUMMARY

According to a first aspect of the present disclosure, there is provided a circuit for a flash analog to digital converter, the circuit comprising: a differential input having a negative input (102) and a positive input (104); a comparator (110) having an output (116), and a first (112) and a second input (114) at a first (A) and a second (B) node respectively; a first (124) and a second (144) reference capacitor [Drafting Note to self: "first" is n-side, "second" is p-side], having first and second reference capacitances respectively, each having a first terminal connected to a respective one of the first and second nodes, and each having a second terminal, connectable to a supply (Vdd) and to a second supply voltage, respectively; a first (122) and a second (142) reservoir capacitor, having first and second reservoir capacitances respectively, each having a first terminal connected to the second supply voltage, and a second terminal connectable to the first and second node, respectively; and a plurality of switches controllable to: during a first, charge-setting, phase connect the second terminals of the first and second reservoir capacitors to the second supply voltage and the supply respectively, and discharge the first and second reference capacitors; during a second, charge-sharing, phase connect the second terminal of the first and second reference capacitors to a supply and the second supply voltage, respectively, and connect the first node and the second node to the respective second terminal of the first and second reservoir capacitors; and during only a third, measurement, phase disconnect the second terminal of the first and second reference capacitors from the supply and the second supply voltage respectively and connect the second terminal of the first and second reference capacitors to the negative and positive input, respectively; wherein a ratio R of the first reservoir capacitance to the first reference capacitance is equal to a ratio of the second reservoir capacitance to the second reference capacitance.

In one or more embodiments, the first and second reservoir capacitances are equal, and the first and second reference capacitances are equal. Balancing the size (that is said the capacity) of the capacitors between the positive and negative side of the differential signal may be useful to ensure an invariant common mode voltage. In some such embodiments, the first and second reservoir capacitance are smaller than the first and second reference capacitances. Providing a smaller reservoir capacitor than the reference capacitors may help to enable a range of different size reference capacitors for different circuits acting as different bit slices of a flash AC, since a smaller reservoir enables a smaller voltage across the reference capacitor after charge sharing; however, for the largest flash level or levels, the reference is or are quite close to Vdd/2, so in practical applications (taking parasitics into account), the reservoir capacitor for this or these levels will typically be selected to be slightly bigger than the reference capacitor to achieve this large reference voltage in all but the smallest flash level (in which the voltage dropped across the reference capacitor is smallest), providing a smaller reservoir enables a larger voltage across the reference capacitor after charge-sharing.

In one or more embodiments the output is a differential output.

In one or more embodiments the plurality of switches are controllable to implement the first, second, and third phases in a repeating sequence. Repeating the charge-setting and charge sharing-phases between each measurement may be useful in minimising errors which may otherwise be caused by charge leakage

In one or more embodiments the third phase comprises a plurality of comparison intervals, with reset intervals therebetween. In some such embodiments, the plurality of switches are controllable to connect the second terminal of the first and second reference capacitors to the negative and positive input, respectively, only during the comparison intervals. Including multiple measurements or comparisons between each charge sharing event may increase the speed of the ADC.

In other such embodiments the comparator is controllable to compare the voltage at the first and second node only during the comparison intervals. Depending on the application, controlling comparator may be more power efficient in controlling switches. In particular, for applications in which the required accuracy can be achieved even when permitting some leakage, multiple flash ADC conversions may be made before doing repeating the first and second phases. A flash ADC conversion in that case consists of enabling and resetting the comparator clock, although switching the other switches during the third phase is not necessary for correct operation.

The circuit may form part of a flash analog to digital converter (ADC).

In one or more embodiments, there may provided a flash ADC comprising a plurality bit-slices, each bit-slice comprising a circuit, as just described, wherein each bit-slice has a different value of R.

According to a second aspect of the present disclosure, there is provided a charge-sharing method of operating a stage of an analog to digital converter (ADC), the stage comprising a comparator (110), first (124) and second (144) reference capacitors each for providing a respective reference voltage, and first (122) and second (142) reservoir capacitors, the method comprising: a first phase, charge-setting, phase comprising: discharging the first and second reference capacitors, discharging the first reservoir capacitor, and charging the second reservoir capacitor to a supply voltage by connecting it between a first supply and a second supply; a second, charge-sharing phase, subsequent to the first phase and comprising: connecting the first reservoir capacitor and the first reference capacitor in series between the first supply and the second supply, thereby sharing charge therebetween to provide a reference voltage across the first reference capacitor, and connecting the second reservoir capacitor and the second reference capacitor in parallel, thereby sharing charge therebetween to provide a second reference voltage across the second reference capacitor, wherein the second reference voltage is equal in magnitude and opposite in sign to the first reference voltage; and a third, measurement, phase, subsequent to the second phase and comprising: connecting a negative input (Vinn) to a first input of the comparator via the first reference capacitor, and connecting a positive input (Vinp) to a second input of the comparator via the second reference capacitor, and providing an output signal at an output of the comparator.

In one or more embodiments, the first and second reservoir capacitances are equal, and the first and second reference capacitances are equal. In one or more embodiments, the first and second reservoir capacitance are smaller than the first and second reference capacitances.

In one or more embodiments, the output is a differential output.

In one or more embodiments: discharging the first reference capacitor comprises closing a first switch (130) connected across it; discharging the second reference capacitor comprises closing a second switch (150) connected across it; the first reservoir capacitor each have a respective first terminal connected to the second supply; discharging the first reservoir comprises closing a third switch (126) connected between a second terminal of the first reservoir capacitor and the second supply; and charging the second reservoir capacitor to a supply voltage comprises closing a fourth switch (146) connected between a second terminal of the second reservoir capacitor and the first supply.

In one or more embodiments: connecting the first reservoir capacitor in series with the first reference capacitor comprises closing a fifth switch (128) between the first terminal of the reference capacitor and the second terminal of the first reservoir capacitor; and connecting the second reservoir capacitor and the second reference capacitor in parallel comprises closing a sixth switch (148) between the first terminal of the reference capacitor and the second terminal of the first reservoir capacitor.

In one or more embodiments: connecting a negative input to a first input of the comparator via the first reference capacitor comprises closing a seventh switch between the negative input and a second terminal of the first reference capacitor; and connecting a positive input (Vinp) to a second input of the comparator via the second reference capacitor comprises closing an eighth switch between the positive input and a second terminal of the second reference capacitor.

In one or more embodiments: the third phase comprises a plurality of comparison intervals, with reset intervals therebetween. In some such embodiments, the plurality of switches are controllable to connect the second terminal of the first and second reference capacitors to the negative and positive input, respectively only during the comparison intervals. In other such embodiments, the comparator is controllable to compare the voltage at the first and second node only during the comparison intervals.

The second supply may be a ground, and the second supply voltage may be a ground voltage.

BRIEF DESCRIPTION OF THE DRAWINGS

Reference will now be made to the accompanying drawings, wherein:

Fig. 1a shows a schematic circuit for an ADC according to one or more embodiments;
FIG. 1b shows an example timing diagram for controlling the switches illustrated in FIG 1a;
Fig. 2, Fig. 3 and Fig. 4 show the circuit of figure 1, during a first, second, and third phase of operation, respectively;
Fig. 5 illustrates various waveforms associated with the circuit of Fig. 1 and associated methods;
Fig. 6 various waveforms associated with other embodiments;
Fig. 7a shows a schematic circuit for an ADC according to other embodiments; and
Fig. 7b shows associated waveforms for the such other embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

DETAILED DESCRIPTION

As mentioned above, typically, the voltage reference levels for the individual comparators for a flash ADC are generated in such a way that the common-mode voltage at the input of the comparators is variable or by dividing the input signal itself. However, most comparators have a finite common-mode input range and suffer from common-mode dependent offsets resulting in non-linearity. Furthermore, dividing the input signal lowers the signal strength, which typically results in the need a more accurate comparator. This circuits and methods according to embodiments of the present disclosure may circumvent these limitations, by generating the voltage levels in such a way that the common-mode voltage is constant for all comparators, without dividing the input signal. Furthermore, according to embodiments, it may not be needed that the input signal is sampled; the reference voltage level for each comparator may be generated by switching capacitors, thereby reducing or even eliminating static power consumption.

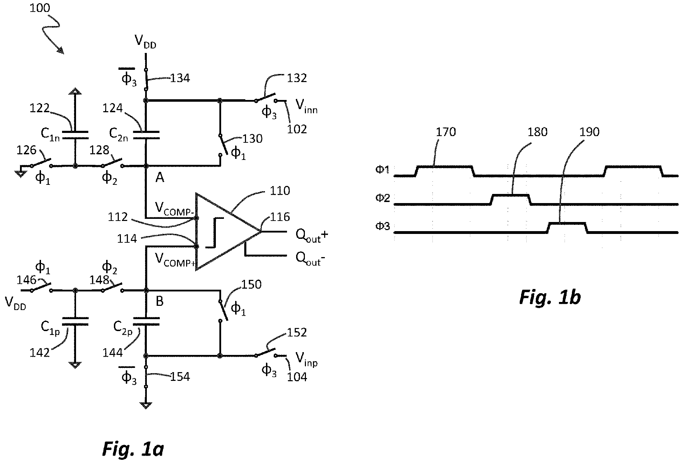

A general principle of the present disclosure is to provide a voltage which is identical, except for its sign, across each of two reference capacitors C2, that is to say $C_{2n}$ 124 and $C_{2p}$ 144 in FIG. 1. This is achieved by means of charge sharing with a pair of reservoir capacitors C1, that is to say $C_{1n}$ 122 and $C_{1p}$ 142 in FIG 1. The charge sharing mechanism, by means of switching the capacitors, will be explained in more detail hereinbelow.

A circuit 100 for an ADC according to one or more embodiments of the present disclosure is shown in FIG. 1a, and FIG. 1b shows an example timing diagram for controlling the switches illustrated in FIG 1a. The circuit comprises a comparator 110, which is a differential comparator. The skilled person will be familiar that a differential comparator compares the voltages at each of its two inputs (VCOMP- 112 and VCOMP+ 114 in FIG1, corresponding to nodes A and B respectively), and provides a signal, indicative of which input as at the higher voltage, at its output 116. The output may be single-ended, or may be, as shown, a further differential signal having both the direct output $Q_{out}$+ and it's inverse $Q_{out}$-. The circuit is configured to compare the magnitude of the input signal (Vinn + Vinp), between the pair of differential inputs 102 and 104, with a refence voltage which, as will be discussed in more detail hereinbelow, corresponds to the supply voltage (VDD) minus the sum of the voltages across the two reference capacitors $C_{2n}$ 122 and $C_{2p}$ 144.

The voltages across the pair of reference capacitors $C_{2n}$ 122 and $C_{2p}$ 144 are each provided by charge sharing with a corresponding pair of reservoir capacitors such as $C_{1n}$ 122 and $C_{1p}$ 142, in a first part of an operating cycle, which first part corresponds to first and second phases $\phi1$ 170 and $\phi2$ 180, illustrated in FIG. 1b. A second part of the operating cycle is a measurement phase $\phi3$ 190. Again, as will be discussed in more detail hereinbelow, the measurement phase $\phi3$ may comprise a single momentary comparison, a single comparison being an integrated over time, or multiple comparisons, each within their own comparison interval.

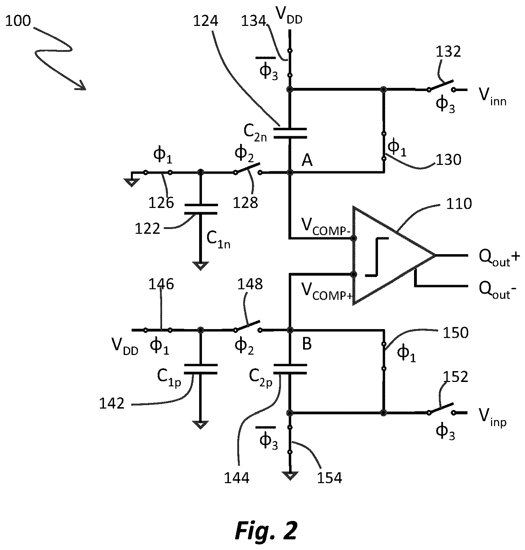

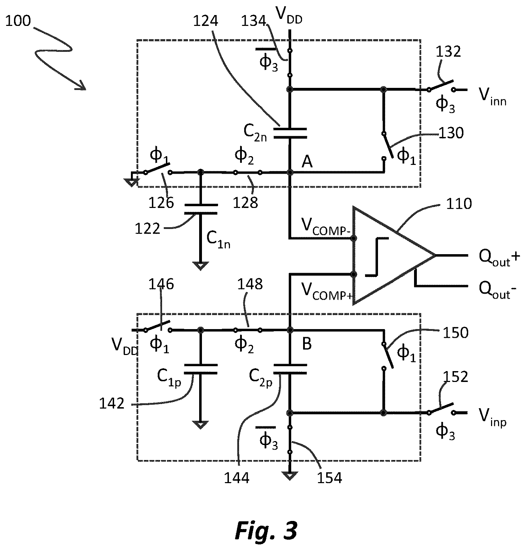

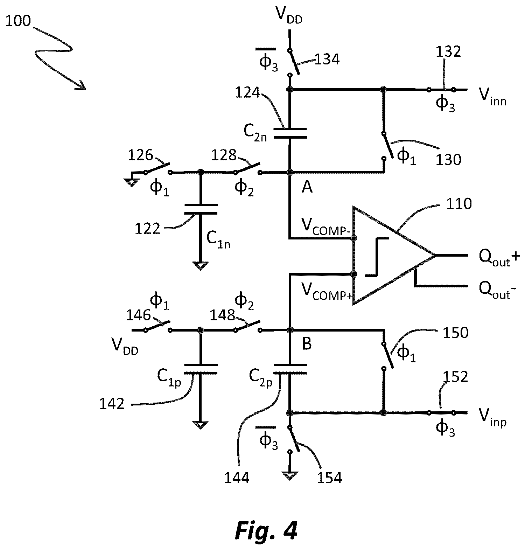

Operation of the circuit of FIG. 1a, will be described with reference to FIG. 2 which shows the configuration of the various switches in the circuit during phase $\phi1$ 170, FIG. 3 which shows the configuration of the switches during phase $\phi2$ 180, and FIG. 4 which shows the configuration of the switches during phase $\phi3$ 190.

Turing to FIG. 2, during the first phase $\phi1$ 170, first reservoir capacitor C1n 122 is discharged (that is to say, both terminals are connected together - in the nonlimiting example shown, both terminals are connected to ground) by means of, for example, a switch 126 connecting one terminal to ground whilst the other terminal is permanently grounded. On the other hand, the second reservoir capacitor C1p 142 is connected between $V_{DD}$ and ground, by means of a switch 146. During this first phase $\phi1$ 170, the first reference capacitor C2n 124 is discharged, for example by closing switch 130 thereby connecting its terminals together as shown, and the second reference capacitor C2p 144 is discharged, for example by closing switch 150 thereby connecting its terminals together as shown. At the end of the first phase, the voltage VCOMP- at node A is equal to VDD, and the voltage VCOMP+ at node B is equal to ground. At the end of the first phase $\phi1$ 170, all of the first phase switches, 126, 130, 146, 150 are opened.

The second phase is subsequent to the first phase, and may follow directly thereafter, or with an interval therebetween. In general, any interval between the first and second phases is kept to a minimum, but may be preferable, or even mandatory, in order to avoid overlap and allow for nonzero slew rate of the switches. For example, in some embodiments, it may be required to ensure that the switches 126, 130, 146, 150 are fully open prior to closure of switches required during the second phase, in order to avoid short-circuiting the supply to ground.

Turing to FIG. 3, during the second phase $\phi2$ 180, switch 128 is closed, placing the first reservoir capacitor C1n 122 in series with the first reference capacitor C2n 124. Switch 134 is closed during this phase (and during the first phase, it being opened only during the third phase), and as a result the series combination of the first reference capacitor and the first reservoir capacitor is connected between $V_{DD}$ and ground. Put another way, during this phase the first reservoir capacitor and the first reference capacitor are connected in series between the supply and the ground. If, as may generally be the case, the ground is defined to be at 0 potential, then the voltage difference is ($V_{DD}$ - 0). This voltage difference shared between the capacitors, in inverse proportion to their capacitances: that is to say, the voltage at node A therebetween settles at:

$$V_{DD} - V_{DD} \cdot (C1n)/(C1n + C2n).$$

Also during the second phase, the switch 148 is closed. This places the second reservoir capacitor C1p 142 in parallel with the second reference capacitor C2p 144, between node B and ground (since switch 154 is also closed, during the first and second phase, and only open during the third phase). The charge on the second reservoir capacitor C1p 142 is shared with the second reference capacitor C2p, which results in the voltage at node B settling to

$$V_{DD} \cdot (C1p)/(C1p + C2p).$$

Thus, provided only that the two reservoir capacitors 122 and 142 have the same capacitance C1, and the two reference capacitors 124 and 144 have the same capacitance C2, the voltages at nodes A and B offset from, respectively, the first and second supply voltages (which are typically, as shown, VDD and ground) by the same (but inverted) voltage. In other words, the resulting voltage after equalization across C2n is identical to the inverse of the voltage across C2p. As a result, the voltage between C2p and C2n becomes a differential voltage, with a constant common-mode regardless of the ratio between C1 and C2.

Turning now to FIG. 4, this shows the arrangements of the switches during a third, measurement phase $\phi 3$ 180. During this phase, one terminal or plate of each of the capacitors C2n 124 and C2p 144, is connected to the respective side of the differential input voltage, Vinn and Vinp respectively, while the other terminal or plate is connected to the corresponding comparator input and node A and B respectively. At the same time, the comparator is powered up, while the comparator inputs are tracking the input signal with the added offset, provided by C2n and C2p. At the comparator inputs, this results in:

$$VCOMP+ = Vinp + VC2p; \qquad VCOMP- = Vinn + VC2n;$$

As the common-mode voltage of VC2p and VC2n is constant, and provided the Vin has a constant common mode voltage, , the common-mode voltage at the comparator input will also be constant.

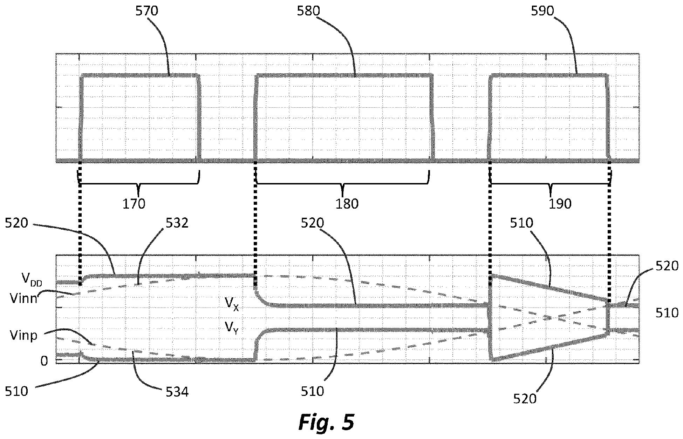

Fig. 5 illustrates various waveforms associated with methods and circuits, as described above. The top part of the figure illustrates example control signals . The switches during each of the first, second, and third phases. For example, the switches may be implemented as field effect transistors (FETs) and signals 570, 580, 590 may be applied to the control terminal of accumulation mode FETs such that the switches are closed, that is to say, the FETs are turned on, when the signals are high. Of course, the skilled person will appreciate that depletion mode FETs may be more appropriate than accumulation mode FETs in some applications, in which case, the signals may be inverted. In any case, control signal, 570 illustrates the time and duration of the first phase 170, control signal, 580 illustrates the time and duration of the second phase, 180, and control signal 590 illustrates the time and duration of the third phase, 190. The lower part of the figure illustrates, at 510, the voltage at the first input to the comparator, that is to say the voltage, $V_{COMP}$-, at node A; also illustrated, at 520, is the voltage at the second input to the comparator, that is to say the voltage, $V_{COMP}$+, at node B. Also shown in the lower part of the figure, as the dashed lines 532 and 534 is a differential input (Vinn and Vinp), which in this nonlimiting example is a fast-varying signal, which reaches a peak during the second phase, 180, and changes sign during the third phase, 190.

Considering the signals $V_{COMP}$-, and $V_{COMP}$+ in more detail: during the first phase, the voltage $V_{COMP}$- at node A is pulled up to the supply voltage of VDD since switch 130 is closed. Furthermore, the voltage $V_{COMP}$+ at node B is pulled down to ground since switch 150 is closed. The voltage change is not instantaneous, as it takes time for charge to flow. However, the first phase may be concluded as soon as the voltages have settled at VDD and 0 respectively, such that, in a practical application, the first phase may be significantly shorter than that shown. In other applications, it may be preferable to control the phases using a clock, in which case it is only required that switches are sufficiently fast closing to enable the voltages to settle within the clock period (or periods, if it is chosen, for reasons of circuit design or otherwise to allocate more than one clock period to the first phase).

This first phase may conveniently be referred to as a "charge-setting" phase, since the charge is "set" according to $V_{DD}$ and the capacitor size in one of the reservoir capacitors (and "set" to 0 in the other reservoir capacitor).

After the conclusion of the first phase, 170, there may be an interval as shown before the second phase commences by the control signal 580 going high. In other embodiments, the second phase follows immediately at the conclusion of the first phase.

The second phase may be referred to as a "charge-sharing" phase, since during this phase charge is shared between each reservoir capacitor and its corresponding reference capacitor. As shown, the voltage $V_{COMP}$- at node A reduces from $V_{DD}$ to an intermediate voltage $V_X$ (set by the ratio R of the capacitances between the reservoir capacitor and reference capacitor as discussed above), since, during this phase, the first reference and first reservoir capacitor connected in series between VDD and ground. At the same time, the voltage $V_{COMP}$+ at node B rises from the ground to a second intermediate value $V_Y$, as the charge on the second reservoir capacitor is shared with the second reference capacitor since these are now connected in parallel. Again, for ease of understanding, the second phase, 180 has been shown with a duration which is much larger than the time required for the relevant switches to fully open and the charge to redistribute.

Again, after the conclusion of the second phase, 180, there may be an interval, as shown, before the third phase commences by the control signal 590 going high. In other embodiments, the third phase follows immediately at the conclusion of the second phase.

During the third phase, as discussed above, the positive and negative parts of the input differential signal are in series with the first and second reference capacitors. The voltage $V_{COMP}$- at node A then becomes equal to Vinn - $V_X$, and voltage $V_{COMP}$+ at node B then becomes equal to Vinp + $V_Y$. But, as explained above, provided the ratio R between the capacitances of the reservoir capacitor and the reference capacitor is the same for each of the first and second pair of capacitors, $V_X = V_Y$, the "offset" provided by the reference capacitors are equal in magnitude (and opposite in sign. This configuration ensures that the common mode voltage on the comparator is un-changing and stable (at $V_{DD}$ / 2 for the configuration shown.)

As shown, the differential signal may be fast changing, in which case, the voltages on the two inputs of the comparator are not flat during the third phase, but may change over time as shown. The skilled person will appreciate that in contrast, for a slow-changing or DC input signal, the voltage levels $V_{COMP}$- and $V_{COMP}$+ at node a and B, respectively, may vary only slightly or not at all.

In some embodiments, the method repeatedly cycles through each of the first, second and third phases. In other words, after each measurement, within phase 190, the method repeats the charge-setting phase 170 and the charge-sharing phase 180. It will be appreciated by the skilled person that the values of $V_{COMP}$- and $V_{COMP}$+ at the end of figure 5 - that is to say at the end of the third phase - do not necessarily correspond to their values at the beginning of the first phase. However, the charge-setting phase resets $V_{COMP}$- and $V_{COMP}$+ to VDD and ground respectively, whatever there are starting values.

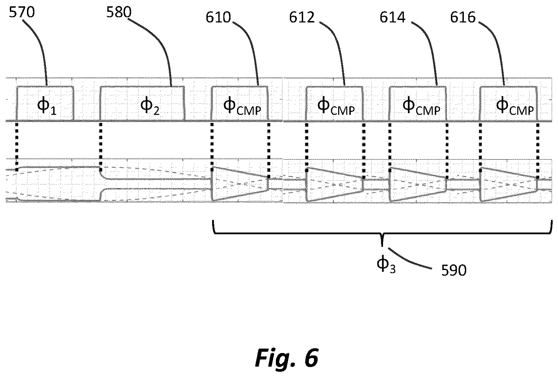

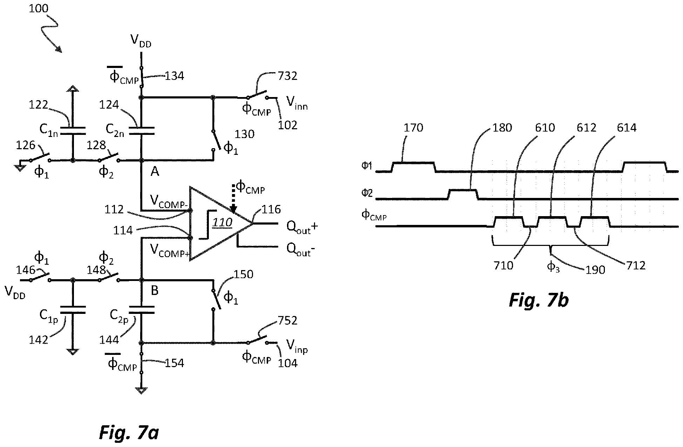

In other embodiments, multiple measurements may be taken by the comparator during an extended measurement phase, which includes multiple comparisons, after each charge-setting and charge-sharing part of the process. This is illustrated in Fig. 6, in which the measurement phase $\phi3$ 590 is extended to include multiple comparisons, 610, 612, 614 and 616, by the comparator. After the final comparison, shown at 616, the method returns to a new charge-setting and charge-sharing part. A possible configuration of the switches for such embodiments is shown in the circuit of Fig. 7a, and Fig.7b shows a corresponding timing that diagram for the switches, according to such embodiments. Fig. 7a is similar to Fig. 1, except that negative and positive sides of the differential input are connected to the second terminals of the reference capacitors 124 and 144, by switches 732 and 752, only during the comparison intervals $\phi_{CMP}$ within the third phase three such measurement intervals 610, 612 and 614, are shown in Fig. 7b, with gap-intervals 710, 712 therebetween. Between the comparison intervals, that is to say in the gap-intervals 710, 712, switches 732 and 752 are open, to disconnect the inputs from the node. Typically, the switches 134 and 154 are not re-closed during the gap-intervals 710 and 712: whereas they could be closed during the gap-intervals 710 and 712, this additional switching is not required, and so is generally not done.

In other embodiments, multiple measurements may be taken by the comparator during an extended measurement phase by clocking or intimately switching on and off the comparator rather than controlling the switches 732 and 752. This is illustrated in Fig. 7a by the dashed control signal 750; the skilled person will recognise that in such embodiments switches 732 and 752 are on during the entirety of the third phase $\phi3$ and not just during the measurements intervals $\phi_{CMP}$ as shown.

In a flash ADC implementation, multiple levels can be created with each circuit having a different ratio, R between C1 and C2. In this way, comparators with a limited common-mode input range can be used in such a flash ADC. Furthermore, the input signal itself is not divided by the capacitors, preventing attenuation which would otherwise result in a requirement for lower noise / lower offset comparators. Circuits, according to the present disclosure may avoid such requirement for high specification (that is to say lower noise or lower offset) comparators and of the ADC may thereby be reduced or minimised).

The skilled person will appreciate that, although the embodiments above have been referenced between a first supply voltage of $V_{DD}$ and a second supply voltage being ground, the disclosure is not limited thereto, and may be equally applicable for a different, non-ground, second supply voltage $V_{SS}$.

The skilled person will further appreciate that, whereas hereinabove connection between two nodes has in general been illustrated by closing switch therebetween, other circuit configurations may be employed as appropriate to the application; thus, as a nonlimiting example, a switch may be replaced by a pair of switches in series, in order to provide increased isolation and in such embodiments. A step of "closing the switch" may be implemented by closing the pair of switches at the same time. As a further nonlimiting example, a switch may be replaced by a pair of switches in parallel having different slew rates or other characteristics, and in such embodiments, a step of "closing the switch may be implemented by initiating the closure of the switch at the same time. Correspondingly, a step of "opening the switch" is to be understood as initiating opening each of multiple switches, as described above. Further, the skilled person will appreciate that embodiments of the present disclosure are not limited to the supply voltage $V_{DD}$ and ground voltage. In general, the supply voltage may be a first supply voltage, and ground is just one, nonlimiting example of a second supply voltage, which may be a ground, or local ground, or other suitable voltage level. It may be represented by $V_{SS}$.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

**Claims**

1.    A circuit for a flash analog to digital converter, the circuit comprising:

a differential input having a negative input (102) and a positive input (104);
a comparator (110) having an output (116), and a first (112) and a second input (114) at a first (A) and a second (B) node respectively;
a first (124) and a second (142) reference capacitor, having first and second reference capacitances respectively, each having a first terminal connected to a respective one of the first and second nodes, and each having a second terminal, connectable to a first supply voltage (Vdd) and to a second supply voltage, respectively;

a first (122) and a second (124) reservoir capacitor, having first and second reservoir capacitances respectively, each having a first terminal connected to second supply voltage, and a second terminal connectable to the first and second node, respectively;
and a plurality of switches controllable to:

during a first, charge-setting, phase

connect the second terminals of the first and second reservoir capacitors to the second supply voltageand the supply respectively, and
discharge the first and second reference capacitors;

during a second, charge-sharing, phase

connect the second terminal of the first and second reference capacitors to the first supply voltage and a second supply voltage, respectively, and
connect the first node and the second node to the respective second terminal of the first and second reservoir capacitors; and

during only a third, measurement, phase

disconnect the second terminal of the first and second reference capacitors from the supply and second supply voltage respectively and
connect the second terminal of the first and second reference capacitors to the negative and positive input, respectively;
wherein a ratio R of the first reservoir capacitance to the first reference capacitance is equal to a ratio of the second reservoir capacitance to the second reference capacitance.

2. The circuit of claim 1, wherein the first and second reservoir capacitances are equal, and the first and second reference capacitances are equal.

3. The circuit of claim 2, wherein the first and second reservoir capacitance are smaller than the first and second reference capacitances.

4. The circuit of any preceding claim, wherein the output is a differential output.

5. The circuit of any preceding claim, wherein the plurality of switches are controllable to implement the first, second, and third phases in a repeating sequence.

6. The circuit of claim 5, wherein the third phase comprises a plurality of comparison intervals, with reset intervals therebetween, wherein plurality of switches are controllable to connect the second terminal of the first and second reference capacitors to the negative and positive input, respectively, only during the comparison intervals.

7. The circuit of claim 5, wherein the third phase comprises a plurality of comparison intervals, with reset intervals therebetween, wherein the comparator is controllable to compare a voltage at the first and second node only during the comparison intervals.

8. A flash analog to digital converter, ADC, comprising the circuit according to any preceding claim.

9. A flash analog to digital converter, ADC, comprising a plurality bit-slices, each bit-slice comprising a circuit according to any of claims 1 to 8, wherein each bit-slice has a different value of R.

10. A charge-sharing method of operating a stage of an analog to digital converter (ADC), the stage comprising a comparator (110), first (124) and second (144) reference capacitors each for providing a respective reference voltage, and first (122) and second (142) reservoir capacitors, the method comprising:

a first phase, charge-setting, phase comprising:

discharging the first and second reference capacitors,

discharging the first reservoir capacitor, and
charging the second reservoir capacitor to a supply voltage by connecting it between a first supply and a second supply;

a second, charge-sharing phase, subsequent to the first phase and comprising:

connecting the first reservoir capacitor and the first reference capacitor in series between the first supply and the second supply, thereby sharing charge therebetween to provide a reference voltage across the first reference capacitor, and
connecting the second reservoir capacitor and the second reference capacitor in parallel, thereby sharing charge therebetween to provide a second reference voltage across the second reference capacitor, wherein the second reference voltage is equal in magnitude and opposite in sign to the first reference voltage; and

a third, measurement, phase, subsequent to the second phase and comprising:

connecting a negative input (Vinn) to a first input of the comparator via the first reference capacitor, and connecting a positive input (Vinp) to a second input of the comparator via the second reference capacitor, and providing an output signal at an output of the comparator.

11. The charge-sharing method of claim 10, wherein the first and second reservoir capacitances are equal, and the first and second reference capacitances are equal.

12. The charge-sharing method of claim 11, wherein the first and second reservoir capacitance are smaller than the first and second reference capacitances.

13. The charge-sharing method of any of claims 10 to 12, wherein:

discharging the first reference capacitor comprises closing a first switch (130) connected across it;
discharging the second reference capacitor comprises closing a second switch (150) connected across it;
the first reservoir capacitor each have a respective first terminal connected to the second supply;
discharging the first reservoir comprises closing a third switch (126) connected between a second terminal of the first reservoir capacitor and the second supply; and
charging the second reservoir capacitor to a supply voltage comprises closing a fourth switch (146) connected between a second terminal of the second reservoir capacitor and the first supply.

14. The charge-sharing method of any of claims 10 to 13, wherein:

connecting the first reservoir capacitor in series with the first reference capacitor comprises closing a fifth switch (128) between the first terminal of the reference capacitor and the second terminal of the first reservoir capacitor; and
connecting the second reservoir capacitor and the second reference capacitor in parallel comprises closing a sixth switch (148) between the first terminal of the reference capacitor and the second terminal of the first reservoir capacitor.

15. The charge-sharing method of any of claims 10 to 14, wherein:

connecting a negative input to a first input of the comparator via the first reference capacitor comprises closing a seventh switch between the negative input and a second terminal of the first reference capacitor; and
connecting a positive input (Vinp) to a second input of the comparator via the second reference capacitor comprises closing an eighth switch between the positive input and a second terminal of the second reference capacitor.

EP 4 651 379 A2

Fig. 1a

Fig. 1b

**Fig. 2**

**Fig. 3**

**Fig. 4**

**Fig. 5**

570   580   610   612   614   616

$\phi_1$   $\phi_2$   $\phi_{CMP}$   $\phi_{CMP}$   $\phi_{CMP}$   $\phi_{CMP}$

$\phi_3$   590

*Fig. 6*

**Fig. 7a**

**Fig. 7b**